# FASCICULE DE BREVET EUROPEEN

(11) **EP 0 462 266 B1**
(45) Date de publication et mention de la délivrance du brevet: **30.08.1995**
(21) Numéro de dépôt: 91902724.3
(22) Date de dépôt: 03.01.1991
(51) Int. Cl.: H05K 3/00, B23K 26/04, H05K 3/40

(54) **PROCEDE DE FABRICATION DE CIRCUITS IMPRIMES SOUPLES ET DISPOSITIF POUR LA MISE EN OUVRE DE CE PROCEDE**
VERFAHREN ZUR HERSTELLUNG VON BIEGSAMEN LEITERPLATTEN UND ANORDNUNG ZUR VERWIRKLICHUNG DIESES VERFAHRENS
METHOD FOR MANUFACTURING FLEXIBLE PRINTED CIRCUITS AND DEVICE FOR IMPLEMENTING THE METHOD

(30) Priorité: 11.01.1990 FR 9000412
(43) Date de publication de la demande: 27.12.1991
(73) Titulaire: NICOLITCH S.A., F-91005 Evry (FR)
(72) Inventeur: GEROME, Jacques, F-68260 Kingersheim (FR); AMBROISE, Jean-Jacques, F-90100 Joncherey (FR)
(74) Mandataire: Nithardt, Roland
(86) Numéro de dépôt international: FR9100001
(87) Numéro de publication internationale: WO9111090

(56) Documents cités:
- EP-A- 0 080 651
- EP-A- 0 168 351
- EP-A- 0 307 766
- DE-A- 3 608 410
- US-A- 4 769 523
- ELECTRONIC PACKAGING AND PRODUCTION. vol. 28, no. 8, août 1988, NEWTON,MASSACHUSETT pages 32 - 34; FJELSTAD: "Design guidelines for flexible circuits"voir page 3, dernier alinéa; figure 2c

## Description

La présente invention concerne un procédé de fabrication de circuits imprimés, notamment de circuits imprimés souples par enlèvement de matière sur une ébauche comportant un substrat diélectrique, des conducteurs métalliques plats collés par un adhésif sur une face supérieure du substrat, et un revêtement isolant couvrant toute l'étendue du circuit imprimé et collé sur lui par un adhésif, dans lequel on enlève de la matière recouvrant au moins une zone déterminée d'un conducteur de façon à le dénuder sur au moins une de ses faces et/ou sur au moins une zone adjacente à un conducteur.

L'invention concerne également un dispositif pour la mise en oeuvre de ce procédé de fabrication de circuits imprimés, notamment de circuits imprimés souples, par enlèvement de matière sur une ébauche comportant un substrat diélectrique, des conducteurs métalliques plats collés par un adhésif sur une face supérieure du substrat, et un revêtement isolant couvrant toute l'étendue du circuit imprimé et collé sur lui par un adhésif, cette matière enlevée étant celle recouvrant au moins une zone déterminée d'un conducteur, de façon à le dénuder sur au moins une de ses faces, ce dispositif comportant un support pour cette ébauche, une tête d'usinage agencée pour usiner l'ébauche par enlèvement de matière, et des moyens de commande et de déplacement pour actionner la tête d'usinage et produire des déplacements relatifs entre elle et l'ébauche, la tête d'usinage comportant au moins un émetteur d'un faisceau laser et des moyens de modulation de la puissance du faisceau laser, les moyens de commande et de déplacement comportant un calculateur commandant la tête d'usinage et étant couplé à une mémoire où sont stockées les coordonnées des zones à usiner sur l'ébauche.

Dans un procédé traditionnel de fabrication de circuits imprimés et plus particulièrement de circuits imprimés souples, ces derniers sont revêtus d'un film isolant fixé par un adhésif et recouvrant tout le substrat et les conducteurs, sauf sur des zones de connexion et sur des zones ménagées sur les conducteurs et à côté d'eux pour le raccordement ou le montage de composants électriques. Le film isolant est préparé avant d'être posé sur un substrat pourvu d'une série de circuits imprimés. La préparation du film isolant consiste à le débiter en formats couvrant plusieurs circuits et à y pratiquer par poinçonnage, par perçage ou fraisage, des ouvertures qui laisseront dégagées les zones de connexion et les zones nues. Ensuite, le film isolant préparé est mis manuellement en position sur le substrat par repérage visuel ou à l'aide d'un gabarit. Le maintien en position est assuré par collage en quelques points, puis l'ensemble est pressé à chaud afin que l'isolant adhère parfaitement sur toute sa surface. On obtient ainsi une bande de circuits prête à être débitée par découpage. Ce procédé utilisant une mise en place manuelle a une productivité très faible, surtout si les zones de connexion et les zones nues sont nombreuses et de petite surface.

Un procédé plus performant, tel que défini en préambule, est décrit dans la publication japonaise Sho. 58 132 996. Il consiste à appliquer le film isolant sensiblement sur toute la surface du substrat, puis l'enlever sur les zones à dénuder, au moyen d'outils mis en vibration latérale par ultra-sons. Un inconvénient de ce procédé est une certaine lenteur si l'on utilise un outil simple, ou bien la nécessité de disposer d'un outillage très complexe pour chaque type de circuits. De plus, la précision obtenue est insuffisante pour des pistes conductrices fines. En outre, un inconvénient inhérent à ce type de procédé est que, en raison de la position saillante des conducteurs sur le substrat, il ne permet pas de dégager les zones du substrat adjacentes à un conducteur ou localisées entre deux conducteurs voisins. Or, ce dégagement est nécessaire pour garantir un bon contact électrique entre le conducteur et l'élément correspondant d'un connecteur.

Un autre procédé d'usinage de circuits imprimés est décrit dans la publication allemande DE-A-36.08.410. Ce procédé utilise un faisceau laser pour enlever des zones de la couche isolante recouvrant les conducteurs, ces zones étant définies par un masque. Ce procédé est limité à l'enlèvement d'une couche de matière isolante et nécessite l'utilisation d'un masque.

Le brevet US-A- 4 769 523 décrit un dispositif d'usinage de plaques semiconductrices. Le dispositif comporte un émetteur d'un faisceau laser, des moyens de commande et de déplacement relatifs entre la tête d'usinage et l'ébauche, un détecteur de position des marques définies sur l'ébauche, des moyens de commande du faisceau laser pour réaliser l'usinage en fonction des marques détectées et un détecteur d'erreur pour détecter la position relative entre l'usinage et lesdites marques. Aucune modulation de puisssance du faisceau laser n'est prévue en fonction des points d'impact dudit faisceau.

Par conséquent, la présente invention a pour but de fournir un procédé permettant d'éviter les inconvénients sus mentionnés et de dénuder aussi bien des zones des conducteurs que des zones adjacentes sur le substrat, avec précision et à une cadence élevée, sans nécessiter un outillage spécifique à chaque type de pièces traitées.

Dans ce but, l'invention fournit un procédé du genre spécifié en préambule, caractérisé en ce que l'on enlève le revêtement isolant et l'adhésif, ou les substrat et la colle, simultanément au moyen d'au moins un faisceau laser avec une puissance préalablement définie pour chacun des points d'impact du faisceau, la valeur de cette puissance étant stockée dans la mémoire d'un calculateur.

Dans une forme avantageuse du procédé, I'ébauche est pourvue de repères imprimés dans des positions déterminées par rapport aux conducteurs, on effectue une détection automatique de ces repères au moyen d'un capteur optique couplé au calculateur commandant le faisceau laser, et l'on commande, en fonction de cette détection, des déplacements relatifs entre le faisceau laser et l'ébauche, ainsi que la puissance du faisceau.

On peut réaliser des trous à travers l'ébauche au moyen du faisceau laser. Si l'ébauche contient plusieurs circuits imprimés distincts, on peut séparer ces circuits par découpage de l'ébauche au moyen du faisceau laser après l'opération d'enlèvement de matière.

Dans le cas où ledit revêtement est formé par un film isolant appliqué sur une couche d'un adhésif polymérisable, une forme avantageuse du procédé prévoit que, pour enlever le film isolant sur une zone, on le découpe au moyen du faisceau laser le long du pourtour de la zone pendant que l'adhésif est incomplètement ou pas du tout polymérisé, on retire le film et l'adhésif de cette zone et l'on assure ultérieurement la polymérisation de l'adhésif situé hors de cette zone.

Pour la mise en oeuvre de ce procédé, l'invention propose un dispositif du type mentionné en préambule, caractérisé en ce que la valeur de la puissance préalablement définie pour chacun des points d'incidence est stockée dans la mémoire, et en ce que les moyens de commande agissent sur les moyens de modulation de puissance en fonction desdites zones à usiner.

Dans une forme de réalisation avantageuse, le support comporte un cylindre rotatif autour de son axe, et la tête d'usinage est mobile en translation parallèlement à cet axe.

Dans les cas où l'ébauche est une bande contenant plusieurs circuits imprimés, le support peut comporter plusieurs cylindres parallèles dont l'un au moins est réglable en position par rapport aux autres et autour desquels la bande forme une boucle sans fin.

De préférence, le dispositif comporte au moins un capteur optique couplé au calculateur et agencé pour détecter des repères sur l'ébauche.

De préférence, le capteur optique est une caméra de prises de vues.

La présente invention et ses avantages seront mieux compris à l'aide de la description de différents exemples de réalisation en référence aux dessins annexés, dans lesquels :
- la figure 1 représente en plan un circuit imprimé fini, réalisé selon l'invention,
- la figure 2 est une vue en coupe suivant la ligne II - II de la figure 1,
- la figure 3 est une vue en coupe suivant la ligne III - III de la figure 1,
- la figure 4 représente une bande portant plusieurs circuits imprimés, avant le découpage final de cette bande,
- la figure 5 représente schématiquement une forme de réalisation d'un dispositif selon l'invention comportant un support en forme de table mobile dans son plan, par rapport à une tête d'usinage,
- la figure 6 représente une forme de réalisation du dispositif comportant un support en forme de cylindre rotatif en face duquel se déplace la tête d'usinage,
- la figure 7 représente une autre forme de réalisation du dispositif, dans laquelle une bande à circuits imprimés forme une boucle fermée qui s'enroule partiellement sur un cylindre placé en face de la tête d'usinage et sur un jeu de rouleaux réglables en position,
- la figure 8 est une vue en coupe partielle d'un circuit imprimé dans lequel le substrat et la colle se trouvant sous un conducteur ont été usinés pour dégager le conducteur, et
- la figure 9 est une vue en coupe partielle d'un circuit imprimé dans lequel un conducteur a été dénudé des deux côtés.

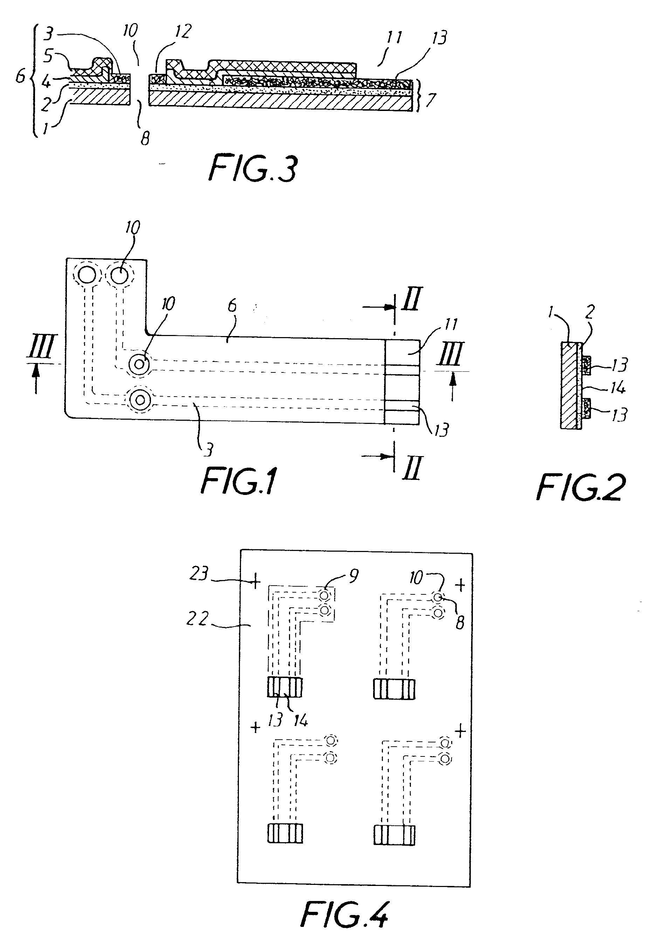

En référence aux figures 1 à 3, le circuit imprimé 6 à fabriquer doit comporter un substrat souple formé par une ieuille diélectrique 1, recouverte d'une couche de colle 2 fixant sur elle des conducteurs métalliques plats 3 réalisés par un procédé quelconque du domaine des circuits imprimés. Un revêtement, constitué par un film isolant 5 fixé par un adhésif 4, a été placé sur toute la surface supérieure de l'ensemble 7 formée par les couches 1, 2 et 3. Il s'agit ensuite d'ôter ce revêtement sur certaines zones afin d'obtenir des dégagements 10 où le métal des conducteurs 3 est dénudé et où l'on peut éventuellement pratiquer des trous 8 à travers le circuit, et un dégagement 11 situé de préférence à une extrémité du circuit et destiné à être branché à un ou plusieurs connecteurs. Le dégagement 11 laisse apparaître des zones de connexion 13 sur les conducteurs et des zones nues 14 adjacentes aux zones 13 sur le substrat 1 ou sur la couche de colle 2.

Comme le montre la figure 4, on fabrique généralement plusieurs circuits imprimés 6 à partir d'une ébauche en forme de bande 22, revêtue des couches 4 et 5 sur toute sa surface. Après réalisation des dégagements 10 et 11 et éventuellement des trous 8, chaque circuit est découpé dans la bande 22 le long de son pourtour 9. La bande 22 porte également des repères imprimés 23, par exemple sous la forme de croix.

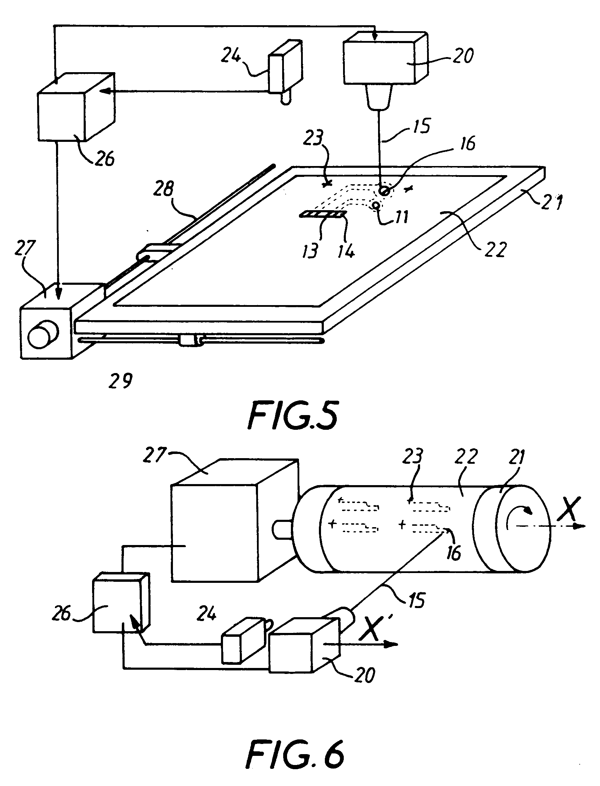

Le dispositif illustré par la figure 5 comporte une tête d'usinage 20 située en face d'un support mobile en forme de table 21 sur laquelle est fixée l'ébauche constituée par la bande 22. La tête d'usinage 20 comporte un émetteur laser émettant un faisceau laser 15 perpendiculaire à la table 21 et atteignant un point 16 sur la bande 22. En fait, la tête 20 peut comporter plusieurs émetteurs laser, produisant des faisceaux parallèles entre eux. Au voisinage de la tête 20 est prévu un capteur optique 24, agencé pour détecter le passage d'un repère 23 devant lui et pour transmettre cette information à un calculateur 26 pourvu d'une mémoire où sont stockées, notamment, les coordonnées des repères 23 et des points définissant les dégagements 10 et 11 à réaliser sur les circuits imprimés. Le calculateur 26 commande d'une part le fonctionnement de l'émetteur laser de la tête 20, et d'autre part une unité de déplacement 27 qui déplace la table 21 dans deux directions perpendiculaires, par exemple au moyen de mécanismes à vis 28, 29.

Un aspect particulièrement intéressant du fonctionnement de ce dispositif est que la puissance du faisceau laser 15 est modulée d'une manière programmée pour chaque point d'incidence 16 sur les circuits. Par exemple, dans un dégagement 11 pour des connecteurs, la puissance du faisceau est ajustée de manière à détruire le film isolant 5 et l'adhésif 4 différemment sur les zones de connexion 13 des conducteurs et sur des zones nues adjacentes 14. Cela permet notamment de mieux dégager les bords des conducteurs 3, où, comme on le voit à la figure 3, le revêtement formé par les couches 4 et 5 est plus épais. La puissance du faisceau laser peut aussi être modulée différemment pour réaliser les trous 8 et pour découper le pourtour 9 des circuits ou encore pour attaquer la feuille 22 par dessous, pour dénuder un conducteur par ablation locale de la feuille 1 et de la couche de colle 2. On définit au préalable la puissance pour chaque point 16 et l'on stocke cette information dans la mémoire associée au calculateur 26. Celui-ci pourra donc commander la puissance du faisceau en combinaison avec la commande des déplacements produits dans l'unité 27.

La figure 6 représente une autre forme de réalisation, dans laquelle la bande ébauche 22 est fixée sur le pourtour d'un support formé par un cylindre 21 entraîné en rotation autour de son axe X par l'unité 27. Dans ce cas, la tête d'usinage 20 est montée de manière mobile en translation le long d'un axe X′ parallèle à l'axe X et elle émet un ou plusieurs faisceaux laser 15 perpendiculairement à l'axe X. La tête 20 avance lentement pendant la rotation du cylindre, de sorte qu'on a un mouvement continu qui peut être plus rapide et plus régulier qu'un mouvement de balayage alternatif. L'avance de la tête pour chaque tour se fait suivant un pas voisin de la largeur du faisceau laser 15, lequel balaye ainsi toute la surface de la bande 22, avec une puissance et à un moment qui dépendent des coordonnées cylindriques des points d'incidence 16 sur la bande 22. Cette forme de réalisation où la bande 22 est totalement enroulée sur le support cylindrique 21 convient particulièrement aux petits circuits, dont le développement dans une direction ne dépasse pas la circonférence du support, et à la fabrication en faibles séries ne mettant pas en jeu de grandes surfaces de matière.

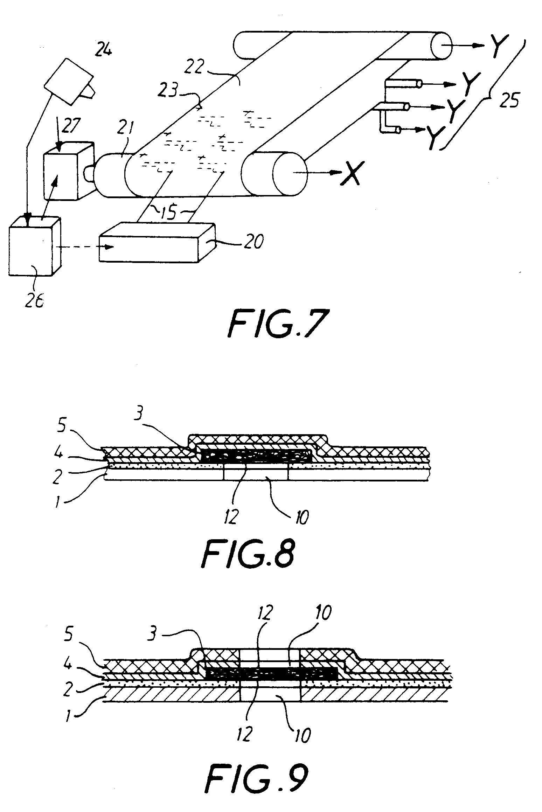

Une variante quelque peu similaire est représentée à la figure 7. Dans ce cas, la bande 22 est continue et forme une boucle fermée qui s'enroule partiellement sur le support cylindrique 21 et sur un ensemble de rouleaux 25 ayant des axes Y parallèles à l'axe X du cylindre 21. Cette solution permet d'utiliser une bande de grande longueur, ce qui convient bien aux grands circuits ou aux grandes séries. De préférence, on prévoit une réglage de la position des rouleaux 25 entre eux ou par rapport au cylindre 21, en fonction de la longueur de la bande 22 à usiner.

Dans les différentes formes de réalisation illustrées par les figures 5 à 7, il faut relever que l'utilisation des repères 23 et du détecteur optique 24 permet avantageusement d'éviter de mettre dans une position prédéterminée et précise la bande 22 sur le support 21, et même de corriger des déviations ou des déformations de la bande si les coordonnées des points d'incidence 16 sont recalées à partir de chaque repère 23, qui sera placé le plus près possible des dégagements 10 et 11. Les mêmes repères sont utilisables pour le perçement des trous 8, généralement dans une deuxième phase qui suit l'exécution des dégagements 10 et 11, et pour le découpage du pourtour 9 des circuits au moyen du ou des faisceaux laser 15.

Dans une variante du procédé, qui peut être avantageuse pour créer des dégagements 10, 11 ayant une grande superficie, on utilise une bande 22 dont l'adhésif 4 est incomplètement ou pas du tout polymérisé sur les zones des dégagements 10 et 11, la polymérisation complète n'étant opérée qu'après l'exécution de ces dégagements. Cette solution permet de ne faire balayer au faisceau laser que le pourtour des dégagements 10, 11 et de découper ainsi des pastilles qu'on peut retirer mécaniquement, au lieu de devoir les brûler ou les vaporiser sur toute leur surface. On gagne ainsi du temps et de l'énergie.

La figure 8 montre un exemple où un dégagement 10 a été créé sur une zone de connexion 12 d'un conducteur 3, à travers la feuille de substrat 1 et la couche de colle 2. Dans le cas de la figure 9, un tel dégagement 10 est ménagé sur chaque face du conducteur 3. Pour attaquer le dessous de la bande 22, on peut prévoir soit de la retourner, soit d'installer une tête d'usinage laser en dessous d'elle.

La présente invention n'est pas limitée aux exemples de réalisation décrits ci-dessus mais elle s'applique à toute modification ou variante couverte par les revendications. Le procédé selon l'invention s'étend non seulement à la fabrication des circuits imprimés dont le revêtement est formé par un film collé, mais aussi aux circuits revêtus d'un film appliqué sous forme liquide qu'on a fait durcir ensuite.

## Revendications

1. Procédé de fabrication de circuits imprimés, notamment de circuits imprimés souples, par enlèvement de matière sur une ébauche **(22)** comportant un substrat diélectrique **(1)**, des conducteurs métalliques plats **(3)** collés par un adhésif **(2)** sur une face supérieure du substrat, et un revêtement isolant **(5)** couvrant toute l'étendue du circuit imprimé **(6)** et collé sur lui par un adhésif **(4)**, dans lequel on enlève de la matière recouvrant au moins une zone déterminée **(12, 13)** d'un conducteur de façon à le dénuder sur au moins une de ses faces et/ou sur au moins une zone **(14)** adjacente à un conducteur, caractérisé en ce que l'on enlève le revêtement isolant **(5)** et l'adhésif **(4)**, ou le substrat **(1)** et la colle **(2)**, simultanément au moyen d'au moins un faisceau laser **(15)** avec une puissance préalablement définie pour chacun des points d'impact **(16)** du faisceau, la valeur de cette puissance étant stockée dans la mémoire d'un calculateur **(26)**.

2. Procédé selon la revendication 1, caractérisé en ce que l'ébauche **(22)** est pourvue de repères imprimés **(23)** dans des positions déterminées par rapport aux conducteurs, en ce que l'on effectue une détection automatique de ces repères au moyen d'un capteur optique **(24)** couplé au calculateur **(26)** commandant le faisceau laser, et en ce que l'on commande, en fonction de cette détection, des déplacements relatifs entre le faisceau laser et l'ébauche, ainsi que la puissance du faisceau.

3. Procédé selon la revendication 1, caractérisé en ce que l'on réalise des trous **(8)** à travers l'ébauche au moyen du faisceau laser.

4. Procédé selon la revendication 1, caractérisé en ce que l'ébauche **(22)** contient plusieurs circuits imprimés **(6)** distincts et en ce que l'on sépare ces circuits par découpage de l'ébauche au moyen du faisceau laser après l'opération d'enlèvement de matière.

5. Procédé selon la revendication 1, dans lequel ledit revêtement est formé par un film isolant **(5)** appliqué sur une couche d'un adhésif polymérisable **(4)**, caractérisé en ce que, pour enlever le film isolant **(5)** sur une zone, on le découpe au moyen du faisceau laser le long du pourtour de la zone alors que l'adhésif est incomplètement ou pas du tout polymérisé, on retire le film et l'adhésif de cette zone et l'on assure ultérieurement la polymérisation de l'adhésif **(4)** situé hors de cette zone.

6. Dispositif pour la mise en oeuvre du procédé de fabrication de circuits imprimés, notamment de circuits imprimés souples, par enlèvement de matière sur une ébauche comportant un substrat diélectrique, des conducteurs métalliques plats collés par un adhésif sur une face supérieure du substrat, et un revêtement isolant couvrant toute l'étendue du circuit imprimé et collé sur lui par un adhésif, cette matière enlevée étant celle recouvrant au moins une zone déterminée d'un conducteur, de façon à le dénuder sur au moins une de ses faces, selon la revendication 1, ce dispositif comportant un support pour cette ébauche, une tête d'usinage agencée pour usiner l'ébauche par enlèvement de matière, et des moyens de commande et de déplacement pour actionner la tête d'usinage et produire des déplacements relatifs entre elle et l'ébauche, la tête d'usinage **(20)** comportant au moins un émetteur d'un faisceau laser **(15)**, et des moyens de modulation de la puissance du faisceau laser **(15)**, les moyens de commande et de déplacement comportant un calculateur **(26)** commandant la tête d'usinage **(20)** et étant couplé à une mémoire où sont stockées les coordonnées des zones à usiner sur l'ébauche **(22)**, caractérisé en ce que la valeur de la puissance préalablement définie pour chacun des points d'incidence est stockée dans cette mémoire, et en ce que ces moyens de commande agissent sur les moyens de modulation de puissance en fonction desdites zones à usiner.

7. Dispositif selon la revendication 6, caractérisé en ce que le support comporte un cylindre **(21)** rotatif autour de son axe, et en ce que la tête d'usinage **(20)** est mobile en translation parallèlement à cet axe.

8. Dispositif selon la revendication 7, dans lequel l'ébauche est une bande **(22)** contenant plusieurs circuits imprimés **(6)**, caractérisé en ce que le support comporte plusieurs cylindres parallèles **(25)** dont l'un au moins est réglable en position par rapport aux autres et autour desquels la bande forme une boucle sans fin.

9. Dispositif selon la revendication 6, caractérisé en ce qu'il comporte au moins un capteur optique **(24)** couplé au calculateur **(26)** et agencé pour détecter des repères **(23)** sur l'ébauche.

10. Dispositif selon la revendication 9, caractérisé en ce que le capteur optique est une caméra de prises de vues.

## Patentansprüche

1. Verfahren zur Herstellung von Leiterplatten, insbesondere biegsamer Leiterplatten, durch Abnahme von Material von einer Rohplatte (22), bestehend aus einem dielektrischen Substrat (1), flachen metallischen Leitern (3), die durch Klebstoff (2) an einer oberen Fläche des Substrats haften, und einer isolierenden Verkleidung (5), die die ganze Ausdehnung der Leiterplatte (6) bedeckt und durch Klebstoff (4) daran befestigt ist, in dem man Material das mindestens ein bestimmten Bereich (12, 13) eines Leiters bedeckt entfernt, so daß er auf einer seiner Seiten und/oder in mindestens einem Bereich einer Zone (14) neben dem Leiter unbedeckt ist, gekennzeichnet dadurch, daß man die Isolierverkleidung (5) und den Klebstoff (4) oder das Substrat (1) und den Klebstoff (2) gleichzeitig mittels mindestens eines Laserbündels (15) entnimmt, mit einer vorher festgelegten Leistung für jeden der Auftreffpunkte (16) des Bündels, wobei der Wert dieser Leistung im Speicher eines Kalkulators (26) gespeichert ist.

2. Verfahren gemäß Anspruch 1, gekennzeichnet dadurch, daß die Rohplatte (22) gedruckte Markierungen (23) in Positionen enthält, die im Verhältnis zu den Leitern festgelegt sind und dadurch, daß man eine automatische Erfassung dieser Markierungen mittels eines optischen Sensors (24) ausführt, der an den Kalkulator (26) angeschlossen ist, welcher das Laserbündel steuert, und dadurch, daß man gemäß dieser Erfassung die relativen Bewegungen zwischen dem Laserbündel und der Rohplatte steuert, sowie auch die Leistung des Laserbündels.

3. Verfahren gemäß Anspruch 1, gekennzeichnet dadurch, daß man mit Hilfe des Laserbündels Löcher (8) durch die Rohplatte schneidet.

4. Verfahren gemäß Anspruch 1, gekennzeichnet dadurch, daß die Rohplatte (22) mehrere getrennte Leiterplatten (6) enthält und man diese Platten durch Schneiden der Rohplatte mittels des Laserbündels nach der Materialabnahme abtrennt.

5. Verfahren gemäß Anspruch 1, in dem die besagte Verkleidung durch einen Isolierfilm (5) gebildet wird, der auf eine Schicht polymerisierbaren Klebstoffs (4) aufgetragen wird, gekennzeichnet dadurch, daß man, um den Isolierfilm in einem Bereich abzunehmen, man diesen mittels eines Laserbündels entlang des Umfangs dieses Bereiches schneidet, während der Klebstoff noch nicht vollständig oder auch noch gar nicht polymerisiert ist, man entnimmt den Film und den Klebstoff aus diesem Bereich und gewährleistet danach die Polymerisierung des Klebstoffs (4) außerhalb dieses Bereichs.

6. Vorrichtung für die Verwirklichung des Verfahrens zur Herstellung von Leiterplatten, insbesondere biegsamen Leiterplatten, durch Materialabnahme von einer Rohplatte, bestehend aus einem dielektrischen Substrat, flachen metallischen Leitern, die durch Klebstoff an einer oberen Fläche des Substrats haften, und einer isolierenden Verkleidung, die die ganze Ausdehnung der Leiterplatte bedeckt und durch Klebstoff daran befestigt ist, wobei das entnommene Material das ist, das mindestens eine bestimmte Zone eines Leiters bedeckt, so daß dieser auf mindestens einer seiner Flächen unbedeckt ist, gemäß Anspruch 1. Diese Vorrichtung enthält einen Träger für diese Rohplatte, einen Bearbeitungskopf um die Rohplatte durch Materialentnahme zu bearbeiten und Steuer- und Bewegungsvorrichtungen, um den Bearbeitungskopf zu betätigen und relative Bewegungen zwischen ihm und der Rohplatte zu produzieren, wobei der Bearbeitungskopf (20) mindestens einen Sender für ein Laserbündel (15) und Mittel zur Modulation der Leistung des Laserbündels (15) enthält, wobei die Steuer- und Bewegungsvorrichtungen einen Kalkulator (26) enthalten, der den Bearbeitungskopf (20) steuert und an einen Speicher angeschlossen ist, in dem die Daten der zu bearbeitenden Bereiche der Rohplatte (22) eingespeichert sind, gekennzeichnet dadurch, daß der Wert der vorher bestimmten Leistung für jeden der Einwirkungspunkte in diesem Speicher eingespeichert ist und dadurch, daß die Steuervorrichtungen auf die Leistungsmodulationsvorrichtungen einwirken, gemäß den zu bearbeitenden Bereichen.

7. Vorrichtung gemäß Anspruch 6, gekennzeichnet dadurch, daß der Träger einen Zylinder (21) enthält, der sich- um seine Achse dreht und daß der Bearbeitungskopf (20) durch Verschiebung parallel zu dieser Achse beweglich ist.

8. Vorrichtung gemäß Anspruch 7, in der die Rohplatte eine Bahn (22) ist, die mehrere Leitplatten (6) enthält, gekennzeichnet dadurch, daß der Träger mehrere parallele Zylinder (25) enthält, von denen mindestens einer in seiner Position zu den anderen einstellbar ist und um die herum die Bahn eine Endlosschlaufe bildet.

9. Vorrichtung gemäß Anspruch 6, gekennzeichnet dadurch daß sie mindestens einen optischen Sensor (24) enthält, der mit dem Kalkulator (26) verbunden ist und die Markierungen (23) auf der Rohplatte erfaßt.

10. Vorrichtung gemäß Anspruch 9, gekennzeichnet dadurch, daß der optische Sensor eine Kamera ist.

## Claims

1. Method for manufacturing printed circuits, and in particular, flexible printed circuits, by removal of material from a blank (22) composed of a dielectric substrate (1), flat metal conductors (3) glued by adhesive (2) on upper surface of substrate and an insulation film (5) covering entire surface of printed circuit (6) and glued to this surface by adhesive (4), in which one removes the material covering at least a specific area (12, 13) of a conductor in such a way that it becomes bare on at least one of its surfaces and/or in one area (14) alongside a conductor, characterised in that one removes the insulation film (5) and the adhesive (4), or the substrate (1) and the glue (2), simultaneously by impact of a laser beam (15) having a predefined power for each of these impact points (16) of the laser beam, the value of the power being stored in the memory of a calculator (26).

2. Method as in claim 1, characterised in that the blank (22) is foreseen with printed markings (23) in positions pre-defined in accordance with conductors and that these markings are automatically detected by an optic sensor (24) connected to a calculator (26) which controls the laser beam and that relative movement between laser beam and blank as well as laser power are controlled in accordance with sensor signal.

3. Method as in claim 1, characterised in that holes (8) are cut in blank by the laser beam.

4. Method as in claim 1, characterised in that the blank (22) contains several distinct printed circuits (6) and that these circuits are separated after completion of material removal operation by cutting blank with the laser beam.

5. Method as in claim 1, in which the said coating is formed by an insulation film (5) applied to a layer of polymerisable adhesive (4), characterised in that, to remove the insulating film (5) from a specific area, one cuts around the circumference of the said area using a laser beam and when the film is not at all or partially polymerised, one removes the film and adhesive from this area whereas the polymerisation of adhesive (4) is continued outside this area.

6. Device for implementing a method of manufacturing of printed circuits, in particular, flexible printed circuits, by removal of material from a blank composed of a dielectric substrate, flat metal conductors glued with adhesive to the upper surface of the substrate and an insulation film covering the entire printed circuit and glued to the latter with adhesive, the material removed being that which covers a predetermined area of -the conductor in such a way that it becomes bare on at least one of its surfaces, as in claim 1, this device comprises a support for this blank, a built-in machining head for removal of material and the means of controlling machining head movement and operation in order to obtain a relative movement between machining head and blank, the machining head (20) comprising at least one laser beam emitter (15) and means for adjusting power of this laser beam (15), the means for control of movement and operation, comprising a calculator (26) controlling machining head (20) and being connected to memory in which coordinates of area of blank (22) to be machined are stored, characterised in that the predefined power value for each of these impact points is stored in this memory and that the means of control adjusts power in accordance with area to be machined.

7. Device as in claim 6, characterised in that the support is composed of a cylinder (21) revolving around its axis and in that the machining head (20) is mobile and effectuates a translation parallel to this axis.

8. Device as in claim 7, in which the blank is a band (22) containing several printed circuits (6), characterised in that the support comprises several parallel cylinders (25) of which the position of at least one is adjustable in relation to the others and around which the blank forms an endless loop.

9. Device as in claim 6, characterised in that it comprises at least one optic sensor (24) connected to calculator (26) and positioned in such a way as to detect markings (23) on blank.

10. Device as in claim 9, characterised in that the optic sensor is a motion camera.
